(19) Europäisches Patentamt
European Patent Office
Office européen des brevets

(11) **EP 0 897 143 B1**

(12) **EUROPÄISCHE PATENTSCHRIFT**

(45) Veröffentlichungstag und Bekanntmachung des Hinweises auf die Patenterteilung:
**04.10.2001  Patentblatt 2001/40**

(51) Int Cl.7: **G05F 3/30**

(21) Anmeldenummer: **98113265.7**

(22) Anmeldetag: **16.07.1998**

(54) **Bandgap-Referenzspannungsquelle und Verfahren zum Betrieben derselben**

Band gap reference voltage source and method for its operation

Source de tension de référence du type Bandgap et procédé pour son opération

(84) Benannte Vertragsstaaten:
**DE FR GB**

(30) Priorität: **14.08.1997  DE 19735381**

(43) Veröffentlichungstag der Anmeldung:
**17.02.1999  Patentblatt 1999/07**

(73) Patentinhaber: **Infineon Technologies AG
81669 München (DE)**

(72) Erfinder: **Kuttner, Franz
9524 St. Ulrich (AT)**

(56) Entgegenhaltungen:
**GB-A- 2 111 223      GB-A- 2 254 211
US-A- 5 563 504**

Anmerkung: Innerhalb von neun Monaten nach der Bekanntmachung des Hinweises auf die Erteilung des europäischen Patents  kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die vorliegende Erfindung betrifft eine Vorrichtung gemäß dem Oberbegriff des Patentanspruchs 1 und ein Verfahren gemäß dem Oberbegriff des Patentanspruchs 7, d.h. eine Bandgap-Referenzspannungsquelle mit einem insbesondere zur Temperaturkompensation vorgesehenen Operationsverstärker und ein Verfahren zum Betreiben einer derartigen Bandgap-Referenzspannungsquelle.

Derartige Referenzspannungsquellen und deren Betrieb sind seit langem bekannt. Das Prinzip dieser Referenzspannungsquellen beruht darauf, daß die Basis-Emitter-Spannung eines Bipolartransistors (oder die Durchlaßspannung einer Diode) als Spannungsreferenz verwendet wird. Diese Spannungsreferenz, deren Größe im folgenden mit $V_{BE}$ bezeichnet wird, ist jedoch relativ stark temperaturabhängig; der Temperaturkoeffizient beträgt bei 0,6 V ungefähr -2 mV/K. Die Temperaturabhängigkeit läßt sich kompensieren, wenn zu der Spannungsreferenz $V_{BE}$ eine entsprechende, nachfolgend als $KV_t$ bezeichnete Temperaturkompensationsspannung addiert wird. Diese Temperaturkompensationsspannung wird vorzugsweise unter Zuhilfenahme eines zweiten Transistors und eines Operationsverstärkers erzeugt und verarbeitet.

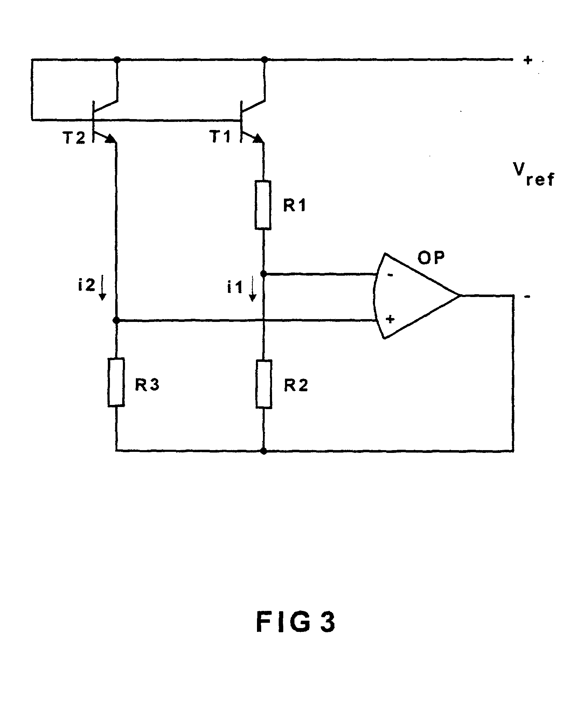

Der prinzipielle Aufbau einer derartigen Anordnung ist in Figur 3 veranschaulicht.

Die Anordnung gemäß Figur 3 umfaßt (Bipolar-)Transistoren T1 und T2, Widerstände R1, R2 und R3 und einen Operationsverstärker OP, welche wie in der Figur 3 gezeigt verschaltet sind.

Die von der gezeigten Anordnung erzeugte Referenzspannung $V_{ref}$ ist

$$V_{ref} = V_{BE2} + K V_t$$

wobei

$$K = \left(\frac{R_2}{R_1}\right) \ln\left(\frac{R_2 A_{E1}}{R_3 A_{E2}}\right)$$

und wobei $A_{E1}$ die Fläche des Emitters des Transistors T1 und $A_{E2}$ die Fläche des Emitters des Transistors T2 ist.

Bei geeigneter Dimensionierung der einzelnen Bauelemente in der Anordnung gemäß Figur 3 kann die Temperaturabhängigkeit der Referenzspannung völlig zum Verschwinden gebracht werden.

In der Praxis gestaltet sich die Erzeugung der Referenzspannung $V_{ref}$ jedoch erheblich komplizierter als es die vorstehenden Erläuterungen vermuten lassen. Verantwortlich hierfür ist vor allem der nahezu unvermeidliche Offset des Operationsverstärkers.

Der Offset eines Operationsverstärkers ist ein bekannter Effekt, der entsteht, wenn der Operationsverstärker einen unsymmetrischen Aufbau aufweist, also beispielsweise wenn die Eingangstransistoren des Operationsverstärkers unterschiedlich groß sind oder die Einsatzspannungen dieser Transistoren unterschiedlich sind; er wirkt wie eine einem der Eingangsanschlüsse des Operationsverstärkers vorgeschaltete (Offset)Spannungsquelle.

Durch das Vorhandensein des Offsets (der Offset-Spannungsquelle) wird die von der Anordnung gemäß Figur 3 erzeugte Referenzspannung $V_{ref}$ zu

$$V_{ref} = V_{BE2} - \left(1 + \frac{R_2}{R_1}\right) V_{OS} + \frac{R_2}{R_1} V_t \ln\left[\frac{R_2 A_{E1}}{R_3 A_{E2}}\left(1 - \frac{V_{OS}}{I_1 R_2}\right)\right]$$

Zur Herleitung dieses bekannten Zusammenhanges wird beispielsweise auf Phillip E. Allen & Douglas R. Hollberg: CMOS Analog Design, Saunders College Publishing, 1987, Seiten 590 bis 596 verwiesen.

Gemäß obiger Formel wird die Referenzspannung also auch vom Offset des Operationsverstärkers beeinflußt; die Spannung $V_{OS}$ der ersatzweise eingeführten Offsetspannungsquelle wird dabei sogar um den Faktor 1+R2/R1 verstärkt am Ausgang des Operationsverstärkers sichtbar.

Bei üblichen Dimensionierungen verwendet man bei den Transistoren ein Emitterflächenverhältnis von 10:1, wodurch 1+R2/R1 ca. 10,5 werden muß, wenn die Temperaturabhängigkeit der Referenzspannung eliminiert werden soll (siehe hierzu auch die vorstehend genannte Literaturstelle).

Bei Realisierung der Bandgap-Referenzspannungsquelle in CMOS-Technik und dem in solchen Fällen üblichen Offset von bis zu 30 mV bedeutet dies, daß die normalerweise etwa 1,2 V betragende Referenzspannung durch den Offset des Operationsverstärkers um bis zu 0,315 V verfälscht werden würde.

Wenn die Streuung des Absolutwertes der Referenzspannung gering gehalten werden soll, muß der Offset kompensiert werden.

Hierzu könnte beispielsweise vorgesehen werden, die Anordnung individuell so zu trimmen, daß der jeweilige Offset zum Verschwinden gebracht wird. Aufgrund der Temperaturabhängigkeit des Offset ist eine derartige Kompensation jedoch nur bei einer ganz bestimmten Temperatur wirksam.

Eine andere Möglichkeit zur Kompensation des Offset besteht darin, den Offset von Zeit zu Zeit zu messen und einen den Offset kompensierenden Kondensator entsprechend aufzuladen. Während des Meß- und Ladevorganges kann der Operationsverstärker jedoch nicht bestimmungsgemäß verwendet werden, wodurch die vom Operationsverstärker ausgegebene Referenzspannung nur mit mehr oder weniger langen Unterbrechungen ausgegeben werden kann. Diese Unterbrechungen treten wiederholt auf, weil der Meß- und Ladevorgang insbesondere aufgrund von Entladevorgängen am Kondensator und der Temperaturabhängigkeit des Offset zyklisch notwendig ist. Benötigt man eine Referenzspannung, die dauerhaft unterbrechungsfrei zur Verfügung steht, so ist eine derartige Offsetkompensation ungeeignet oder jedenfalls nicht optimal geeignet.

Eine andere allgemeine Diskussion von Bandgap-Referenzspannungsquellen kann zum Beispiel Tietze-Schenk, Halbleiterschaltungstechnik, 10. Auflage, 1994, Seiten 558 ff entnommen werden. Dort wird ein Operationsverstärker zum Vergleich zweier Spannungen eingesetzt, die den Basis-Emitter-Spannungen zweier Bipolartransistoren proportional ist. Eine andere Bandgap-Spannungsreferenz ergibt sich aus EP 0 661 616, wo die erzeugte Spannungsreferenz einem Verstärker mit hohem Verstärkungsfaktor zugeführt wird. Das so verstärkte Signal wird einem Spannungsregulierer zugeführt, der die Versorgungsspannung der Schaltung zur Erzeugung der Bandgap-Spannungsreferenz reguliert. Schließlich ist aus DE 41 24 427 eine Bandgap-Referenzspannungsquelle bekannt geworden, bei der durch Einstellen eines Kanalwiderstandsverhältnisses eine verbesserte Unabhängigkeit gegenüber Temperatureinflüssen erzielt wird.

Der vorliegenden Erfindung liegt die Aufgabe zugrunde, die Bandgap-Referenzspannungsquelle gemäß dem Oberbegriff des Patentanspruchs 1 bzw. das Verfahren zum Betreiben einer Bandgap-Referenzspannungsquelle gemäß dem Oberbegriff des Patentanspruchs 7 derart weiterzubilden, daß die Bandgap-Referenzspannungsquelle in der Lage ist, unterbrechungsfrei eine unter allen Umständen temperatur- und offsetkompensierte Referenzspannung auszugeben.

Diese Aufgabe wird erfindungsgemäß durch die im kennzeichnenden Teil des Patentanspruchs 1 beanspruchten Merkmale bzw. durch die im kennzeichnenden Teil des Patentanspruchs 7 beanspruchten Merkmale gelöst.

Demnach ist vorgesehen,

- daß die Bandgap-Referenzspannungsquelle eine Schalteinrichtung enthält, welche derart ausgebildet ist, daß durch deren Betätigung die Eingangssignale des Operationsverstärkers oder dessen Eingangsstufen vertauschbar sind und/oder das Ausgangssignal des Operationsverstärkers wahlweise basierend auf dem Potential eines Knotenpunktes einer ersten Eingangsstufe oder dem Potential eines Knotenpunktes einer zweiten Eingangsstufe erzeugbar ist (kennzeichnender Teil des Patentanspruchs 1) bzw.

- daß die Bandgap-Referenzspannungsquelle zyklisch zwischen zwei Zuständen hin- und hergeschaltet wird, wobei im ersten Zustand ein erstes Eingangssignal des Operationsverstärkers an eine erste Eingangsstufe desselben angelegt wird, ein zweites Eingangssignal des Operationsverstärkers an eine zweite Eingangsstufe desselben angelegt wird, und/oder das Ausgangssignal des Operationsverstärkers basierend auf dem Potential eines Knotenpunktes der zweiten Eingangsstufe erzeugt wird, und wobei im zweiten Zustand das erste Eingangssignal des Operationsverstärkers an die zweite Eingangsstufe desselben angelegt wird, das zweite Eingangssignal des Operationsverstärkers an die erste Eingangsstufe desselben angelegt wird, und/oder das Ausgangssignal des Operationsverstärkers basierend auf dem Potential eines Knotenpunktes der ersten Eingangsstufe erzeugt wird (kennzeichnender Teil des Patentanspruchs 7).

Das Umschalten der Schalteinrichtung bewirkt eine vorzeichen- und/oder betragsmäßige Variation der Auswirkungen der Offset-Ursache auf das Ausgangssignal des Operationsverstärkers (die zu erzeugende Referenzspannung).

Führt man das Umschalten wiederholt durch und filtert die dadurch hervorgerufenen Schwankungen im Ausgangssignal der Operationsverstärkers durch einen geeigneten Filter (beispielsweise einen Tiefpaß-Filter) aus, so erhält man im Ergebnis eine weniger oder überhaupt nicht mehr vom Offset des Operationsverstärkers beeinflußte Referenzspannung.

Es wurden mithin eine Bandgap-Referenzspannungsquelle und ein Verfahren zum Betreiben einer Bandgap-Referenzspannungsquelle geschaffen, durch die es auf relativ einfache Weise möglich ist, eine unter allen Umständen temperatur- und offsetkompensierte Referenzspannung unterbrechungsfrei zu erzeugen.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert. Es zeigen

Figur 1        den Schaltplan eines hinsichtlich der Offsetkompensation zentrale Bedeutung aufweisenden Teils der erfindungsgemäßen Bandgap-Referenzspannungsquelle,

Figur 2        den Schaltungsteil gemäß Figur 1 in einem umgeschalteten Zustand, und

Figur 3        den prinzipiellen Aufbau einer Bandgap-Referenzspannungsquelle.

Die im folgenden näher beschriebene Bandgap-Referenzspannungsquelle ist Bestandteil einer CMOS-Schaltung.

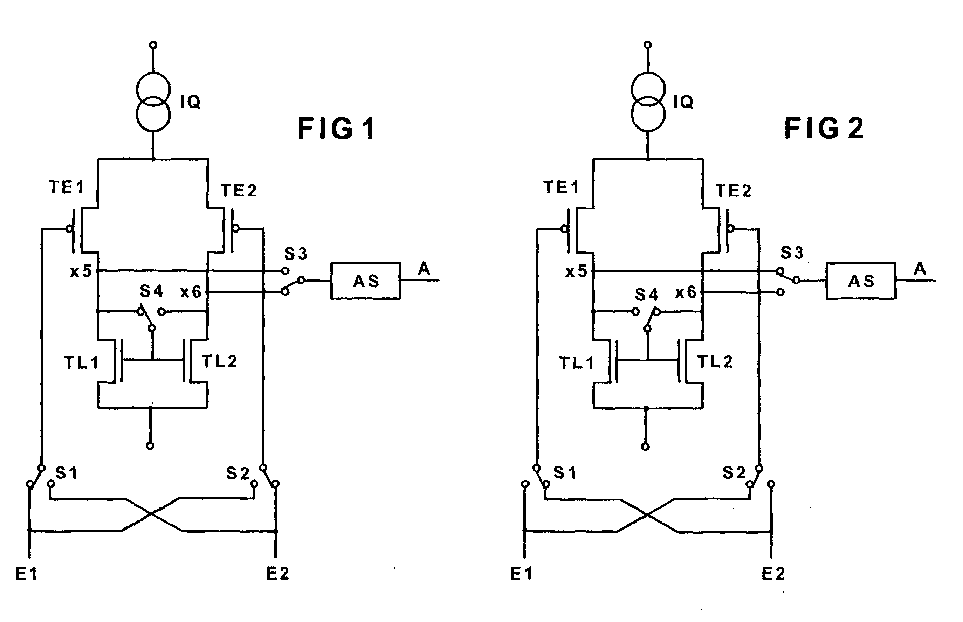

Die angestrebte Offsetkompensation wird dadurch erreicht, daß zyklisch wechselnd die in den Figuren 1 und 2 dargestellten Zustände hergestellt werden.

Die Figuren 1 und 2 zeigen Teile des Operationsverstärker und dessen Zu- und Ableitungen; diejenigen Teile des Operationsverstärkers, welche für die folgenden Erläuterungen nicht oder jedenfalls nicht von wesentlicher Bedeutung sind, also beispielsweise die Bias-Schaltung und die Startup-Schaltung des Operationsverstärkers sind in den Figuren nicht dargestellt.

Der gezeigte Operationsverstärker ist zur Eingabe eines ersten Eingangssignals E1 und eines zweiten Eingangssignals E2 und zur Ausgabe eines Ausgangssignals A ausgelegt.

Der Operationsverstärker, genauer gesagt der dargestellte Teil desselben besteht aus ersten und zweiten Eingangstransistoren TE1 und TE2, ersten und zweiten Lasttransitoren TL1 und TL2 und einer Ausgangsstufe AS, welche wie in den Figuren 1 und 2 gezeigt verschaltet sind; der Operationsverstärker wird von einer Stromquelle IQ mit Energie versorgt.

Der erste Eingangstransistor TE1 und der erste Lasttransistor TL1 bilden eine erste Eingangsstufe (eine Eingangsstufe für das eine der Operationsverstärker-Eingangssignale), und der zweite Eingangstransistor TE2 und der zweite Lasttransistor TL2 bilden eine zweite Eingangsstufe (eine Eingangsstufe für das andere der Operationsverstärker-Eingangssignale). Zwischen dem ersten Eingangstransistor TE1 und dem ersten Lasttransistor TL1 befindet sich ein erster Knotenpunkt x5, und zwischen dem zweiten Eingangstransistor TE2 und dem zweiten Lasttransistor TL2 befindet sich ein zweiter Knotenpunkt x6.

Die Eingangssignale E1 und E2 werden an die Gateanschlüsse der Eingangstransitoren TE1 und TE2 angelegt, und das Ausgangssignal ist das von der Ausgangsstufe ausgegebene Signal.

Bei herkömmlichen Bandgap-Referenzspannungsquellen werden bzw. sind

- das erste Eingangssignal E1 auf den Gateanschluß des ersten Eingangstransistors TE1 gelegt,

- das zweite Eingangssignal E2 auf den Gateanschluß des zweiten Eingangstransistors TE2 gelegt,

- als Eingangssignal der Ausgangsstufe AS das Potential des Knotenpunktes x6 der zweiten Eingangsstufe verwendet, und

- die Gateanschlüsse der Lasttransistoren TL1 und TL2 mit dem Knotenpunkt x5 der ersten Eingangsstufe verbunden.

Dieser Zustand ist in der Figur 1 veranschaulicht.

Anders als bei herkömmlichen Bandgap-Referenzspannungsquellen ist dieser Zustand bei der vorliegenden Bandgap-Referenzspannungsquelle nicht dauerhaft, sondern es wird wiederholt zwischen diesem und einem in der Figur 2 veranschaulichten zweiten Zustand umgeschaltet.

Bei dem zweiten Zustand gemäß Figur 2 werden bzw. sind (anders als beim ersten Zustand gemäß Figur 1)

- das erste Eingangssignal E1 auf den Gateanschluß des zweiten Eingangstransistors TE2 gelegt,

- das zweite Eingangssignal E2 auf den Gateanschluß des ersten Eingangstransistors TE1 gelegt,

- als Eingangssignal der Ausgangsstufe AS das Potential des Knotenpunktes x5 der ersten Eingangsstufe verwendet, und

- die Gateanschlüsse der Lasttransistoren TL1 und TL2 mit dem Knotenpunkt x6 der zweiten Eingangsstufe verbunden.

Im Ergebnis werden dadurch die Eingangssignale des Operationsverstärkers oder dessen Eingangsstufen vertauscht und das Ausgangssignal des Operationsverstärkers abwechselnd basierend auf dem Potential des Knotenpunktes x5 der ersten Eingangsstufe oder dem Potential des Knotenpunktes x6 der zweiten Eingangsstufe erzeugt.

Zum Umschalten zwischen den in den Figuren 1 und 2 gezeigten Zuständen ist eine in herkömmlichen Bandgap-Referenzspannungsquellen nicht vorhandene Schalteinrichtung vorgesehen. Diese Schalteinrichtung ist in den Figuren 1 und 2 durch Schalter S1, S2, S3 und S4 repräsentiert, welche in der Praxis vorzugsweise durch Transistoren (Transistor-Pärchen) gebildet werden. Durch ein Umschalten dieser Schalter S1 bis S4 kann zwischen den in den Figuren 1 und 2 veranschaulichten Zuständen hin- und hergeschaltet werden.

Von den Schaltern S1 bis S4 dient

- der Schalter S1 dazu, das erste Eingangssignal E1 wahlweise entweder der ersten Eingangsstufe oder der zweiten Eingangsstufe zuzuführen,

- der Schalter S2 dazu, das zweite Eingangssignal E2 wahlweise entweder der ersten Eingangsstufe oder der zweiten Eingangsstufe zuzuführen,

- der Schalter S3 dazu, der Ausgangsstufe AS als Eingangssignal wahlweise entweder das Potential des Knotenpunktes x5 der ersten Eingangsstufe oder das Potential des Knotenpunktes x6 der zweiten Eingangsstufe zuzuführen, und

- der Schalter S4 dazu, wahlweise entweder das Potential des Knotenpunktes x5 der ersten Eingangsstufe oder das Potential des Knotenpunktes x6 der zweiten Eingangsstufe als Gatespannung an die Lasttransistoren TL1, TL2 anzulegen.

Die Eingangsstufen des Operationsverstärkers sind so ausgelegt, daß kein systematischer Offset auftreten kann. D.h., die einzelnen Elemente der Eingangsstufen sind so beschaffen und verschaltet, daß sich - wenn es keine zufälligen Unsymmetrien gäbe - im eingeschwungenen (stationären) Zustand der Anordnung, in welchem die Eingangssignale E1 und E2 bekanntlich gleich groß sind, an den Eingangstransistoren TE1 und TE2 einerseits und an den Lasttransistoren TL1 und TL2 andererseits die selben Source-Drain-Spannungen und Gate-Spannungen einstellen, wodurch sich die Knoten x5 und x6 dauerhaft auf gleichem Potential befinden (müßten).

Wie vorstehend bereits erwähnt wurde, sind zufällige Unsymmetrien in den Eingangsstufen jedoch nahezu unvermeidlich, wodurch die Potentiale an den Knoten x5 und x6 nur in den seltensten Fällen genau gleich sind. Die vorhandenen (für das Auftreten des Offset verantwortlichen) Differenzen sind jedoch so klein, daß durch das Umschalten vom Zustand gemäß Figur 1 in den Zustand gemäß Figur 2 zwar Veränderungen, aber keine oder jedenfalls keine nennenswerten Einschwingvorgänge in der Ausgangsstufe AS und deren Ausgangssignal A entstehen.

Das abwechselnd am Knoten x5 und x6 abgegriffene Ausgangsstufen-Eingangssignal und damit auch das Ausgangssignal A des Operationsverstärkers selbst schwanken im Takt der Umschaltung. Das Ausgangssignal schwankt dabei zwischen dem temperatur- und offsetkompensierten Referenzspannungs-Sollwert (ca. 1,2 V) plus der Offsetspannung und dem Referenzspannungs-Sollwert minus der Offsetspannung.

Diese Schwankung kommt dadurch zustande, daß der Offset durch das Umschalten vom Zustand gemäß Figur 1 in den Zustand gemäß Figur 2 und umgekehrt (durch das Vertauschen der ungleichen Eingangsstufen) jeweils eine vorzeichen- und/oder betragsmäßige Variation der Auswirkungen der Offset-Ursache auf das Ausgangssignal A (die zu erzeugende Referenzspannung) stattfindet.

Filtert man die Schwankungen des Ausgangssignals durch ein entsprechendes Filter heraus, so erhält man im Ergebnis ein den bestimmungsgemäßen Sollwert von ca. 1,2 V aufweisendes oder jedenfalls nahekommendes, temperatur- und offsetkompensiertes (Gleichstrom-)Ausgangssignal.

Das besagte Filter wird in der Praxis außerhalb des Operationsverstärkers vorgesehen werden; grundsätzlich kann es aber auch innerhalb des Operationsverstärkers vorgesehen sein und dort entweder das Ausgangsstufen-Eingangssignal oder das Ausgangsstufen-Ausgangssignal oder beide Signale filtern.

Ähnliches gilt für die Schalter S1 bis S4. Auch diese, genauer gesagt die diese repräsentierenden Schaltelemente wie Transistoren und dergleichen können zumindest teilweise entweder innerhalb oder außerhalb des Operationsverstärkers vorgesehen werden.

Der Takt, in dem die Schalter S1 bis S4 umgeschaltet werden, hat vorzugsweise ein symmetrisches Tastverhältnis. Das erwähnte Filter (beispielsweise ein Tiefpaßfilter) soll insbesondere Störungen, die taktfrequent sind oder bei ganzzahligen Vielfachen der Taktfrequenz auftreten, wegfiltern. Derartige Filter sind äußerst einfach (beispielsweise als RC-Filter) realisierbar.

Zusammenfassend kann abschließend festgestellt werden, daß es auf verblüffend einfache Weise gelungen ist, eine Bandgap-Referenzspannungsquelle und ein Verfahren zum Betreiben einer Bandgap-Referenzspannungsquelle zu schaffen, durch welche es möglich ist, eine unter allen Umständen temperatur- und offsetkompensierte Referenzspannung unterbrechungsfrei zu erzeugen.

**Patentansprüche**

1. Bandgap-Referenzspannungsquelle mit einem insbesondere zur Temperaturkompensation vorgesehenen Operationsverstärker (OP), wobei der Operationsverstärker eine erste Eingangsstufe (TE1, TL1) mit einem ersten Lasttransistor (TL1), an der das Potential eines ersten Knotenpunktes (x5) abgreifbar ist, und eine zweite Eingangsstufe (TE2, TL2) mit ein
em zweiten Lasttransistor (TL2), an der das Potential eines zweiten Knotenpunktes (x6) abgreifbar ist, aufweist,
**dadurch gekennzeichnet daß,**
die erste und die zweite Eingangsstufe ein Ausgangssignal (A) abgeben und eine Schalteinrichtung (S1 bis S4) vorgesehen ist, welche derart ausgebildet ist, **daß** durch deren Betätigung der ersten Eingangsstufe (TE1, TL1) abwechselnd ein erstes Eingangssignal (E1) oder ein zweites Eingangsignal (E2) zugeführt wird und der zweiten Eingangsstufe (TE2, TL2) abwechselnd das zweite Eingangssignal (E2) oder das erste Eingangssignal (E1) zugeführt wird, und **daß** durch deren Betätigung das Ausgangssignal (A) des Operationsverstärkers wahlweise von dem ersten Knotenpunkt (x5) oder von dem zweiten Knotenpunkt (x6) abgegriffen und entweder das Potential des ersten Knotenpunktes (x5) oder das Potential des zweiten Knotenpunktes (x6) als Gatespannung an den ersten und den zweiten Lasttransistor (TL1, TL2) angelegt wird.

2. Bandgap-Referenzspannungsquelle nach Anspruch 1,
**dadurch gekennzeichnet,**
**daß** die erste Eingangsstufe (TE1, TL1) und die zweite Eingangsstufe (TE2, TL2) derart aufgebaut sind, daß sich an den jeweiligen Knotenpunkten (x5, x6) im fehler- und störungsfreien Zustand bei identischen Eingangssignalen (EI, E2) die selben Potentiale und Potentialverläufe einstellen.

3. Bandgap-Referenzspannungsquelle nach Anspruch 1 oder 2,
**dadurch gekennzeichnet,**
**daß** eine Steuereinrichtung vorgesehen ist, durch welche die Schalteinrichtung (S1 bis S4) zyklisch betätigt wird.

4. Bandgap-Referenzspannungsquelle nach Anspruch 3,
**dadurch gekennzeichnet,**
**daß** der Takt, in welchem die Schalteinrichtung (S1 bis 34) betätigt wird, zeitlich konstant ist.

5. Bandgap-Referenzspannungsquelle nach Anspruch 3 oder 4,
**dadurch gekennzeichnet,**
**daß** der Takt, in welchem die Schalteinrichtung (S1 bis S4) betätigt wird, ein symmetrisches Tastverhältnis aufweist.

6. Bandgap-Referenzspannungsquelle nach einem der vorhergehenden Ansprüche,
**dadurch gekennzeichnet,**
**daß** ein Filter vorgesehen ist, durch welches aus dem Ausgangsstufen-Eingangssignal oder aus dem Ausgangsstufen-Ausgangssignal insbesondere Schwingungen herausfilterbar sind, deren Frequenz der Umschalt-Taktfrequenz und ganzzahligen Vielfachen hiervon entspricht.

7. Verfahren zum Betreiben einer Bandgap-Referenzspannungsquelle mit einem insbesondere zur Temperaturkompensation vorgesehenen Operationsverstärker (OP), wobei der Operationsverstärker eine erste Eingangsstufe (TE1, TL1) mit einem ersten Lasttransistor (TL1), an der das Potential eines ersten Knotenpunktes (x5) abgreifbar ist, und eine zweite Eingangsstufe (TE2, TL2) mit einem zweiten Lasttransistor (TL2), an der das Potential eines zweiten Knotenpunktes (x6) abgreifbar ist, aufweist,
**dadurch gekennzeichnet,**
**daß** die Bandgap-Referenzspannungsquelle zyklisch zwischen zwei Zuständen hin- und hergeschaltet wird, wobei im ersten Zustand das erste Eingangssignal (E1) an die erste Eingangsstufe (TE1, TL1) angelegt wird, das zweite Eingangssignal (E2) an die zweite Eingangsstufe (TE2, TL2) angelegt wird, und ein Ausgangssignal (A) der Eingangsstufe des Operationsverstärkers am zweiten Knotenpunkt (x6) abgegriffen und das Potential des ersten Knotenpunktes (x5) als Gatespannung an den ersten Lasttransistor (TL1) angelegt wird, und wobei im zweiten Zustand das erste Eingangssignal (E1) an die zweite Eingangsstufe (TE2, TL2) angelegt wird, das zweite Eingangssignal (E2) an die erste Eingangsstufe (TE1, TL1) angelegt wird, und das Ausgangssignal (A) am ersten Knotenpunkt (x5) abgegriffen und das Potential des zweiten Knotenpunktes (x6) als Gatespannung an den zweiten Lasttransistor (TL2) angelegt wird.

## Claims

1. Bandgap reference voltage source having an operational amplifier (OP) provided in particular for the purpose of temperature compensation, the operational amplifier having a first input stage (TE1, TL1) with a first load transistor (TL1), at which stage the potential of a first node (x5) can be picked off, and a second input stage (TE2, TL2) with a second load transistor (TL2), at which stage the potential of a second node (x6) can be picked off,
   **characterized in that**
   the first and second input stages output an output signal (A) and a switching device (S1 to S4) is provided which is designed in such a way that, by actuation thereof, a first input signal (E1) or a second input signal (E2) is alternately fed to the first input stage (TE1, TL1) and the second input signal (E2) or the first input signal (E1) is alternately fed to the second input stage (TE2, TL2), and that, by actuation thereof, the output signal (A) of the operational amplifier is optionally picked off from the first node (x5) or from the second node (x6) and either the potential of the first node (x5) or the potential of the second node (x6) is applied as gate voltage to the first and the second load transistor (TL1, TL2).

2. Bandgap reference voltage source according to Claim 1,
   **characterized in that**
   the first input stage (TE1, TL1), and the second input stage (TE2, TL2) are constructed in such a way that the same potentials and potential profiles are established at the respective nodes (x5, x6) in the error- and interference-free state, given identical input signals (E1, E2).

3. The bandgap reference voltage source according to Claim 1 or 2,
   **characterized in that**
   a control device is provided which cyclically actuates the switching device (S1 to S4).

4. Bandgap reference voltage source according to Claim 3,
   **characterized in that**
   the clock cycle within which the switching device (S1 to S4) is actuated is constant over time.

5. Bandgap reference voltage source according to Claim 3 or 4,
   **characterized in that**
   the clock cycle within which the switching device (S1 to S4) is actuated has a symmetrical duty ratio.

6. Bandgap reference voltage source according to one of the preceding claims,
   **characterized in that**
   a filter is provided which enables in particular oscillations whose frequency corresponds to the switchover clock frequency and integer multiples thereof to be filtered out of the output stage input signal or out of the output stage output signal.

7. Method for operating a bandgap reference voltage source having an operational amplifier (OP) provided in particular for the purpose of temperature compensation, the operational amplifier having a first input stage (TE1, TL1) with a first load transistor (TL1), at which stage the potential of a first node (x5) can be picked off, and a second input stage (TE2, TL2) with a second load transistor (TL2), at which stage the potential of a second node (x6) can be picked off,
   **characterized in that**
   the bandgap reference voltage source is switched back and forth cyclically between two states, in the first state the first input signal (E1) being applied to the first input stage (TE1, TL1), the second input signal (E2) being applied to the second input stage (TE2, TL2), and an output signal (A) of the input stage of the operational amplifier being picked off at the second node (x6) and the potential of the first node (x5) being applied as gate voltage to the first load transistor (TL1), and in the second state the first input signal (E1) being applied to the second input stage (TE2, TL2), the second input signal (E2) being applied to the first input stage (TE1, TL1), and the output signal (A) being picked off at the first node (x5) and the potential of the second node (x6) being applied as gate voltage to the second load transistor (TL2).

## Revendications

1. Source de tension de référence à barrière de potentiel comportant un amplificateur (OP) opérationnel prévu notamment pour la compensation de température, l'amplificateur opérationnel comportant un premier étage (TE1, TL1) d'entrée qui comprend un premier transistor (TL1) de charge et sur lequel le potentiel d'un premier point (x5) nodal peut être prélevé, et comportant un deuxième étage (TE2, TL2) d'entrée qui comprend un deuxième transistor (TL2) de charge et sur lequel le potentiel d'un deuxième point (x6) nodal peut être prélevé, **caractérisée en ce que** le premier et le deuxième étage d'entrée foumissent un signal (A) de sortie et il est prévu un dispositif (S1 à S4) de commutation qui est réalisé de telle manière que, par son actionnement, il est envoyé au premier étage (TE1, TL1) d'entrée alternativement un premier signal (E1) d'entrée ou un deuxième signal (E2) d'entrée et il est envoyé au deuxième étage (TE2, TL2) d'entrée alternativement le deuxième signal (E2) d'entrée ou le premier signal (E1) d'entrée, et **en ce que**, par son actionnement, le signal (A) de sortie de l'amplificateur opérationnel peut être prélevé au choix du premier point (x5) nodal ou du deuxième point (x6) nodal et le potentiel du premier point (x5) nodal ou le potentiel du deuxième point (x6) nodal est appliqué comme tension de grille au premier et au deuxième transistors (TL1, TL2) de charge.

2. Source de tension de référence à barrière de potentiel suivant la revendication 1, **caractérisée en ce que** le premier étage (TE1, TL1) d'entrée et le deuxième étage (TL2, TE2) d'entrée sont constitués de telle manière qu'il s'établit sur les points (x5, x6) nodaux associés, en l'état exempt d'erreur et de parasite, pour des signaux (E1, E2) d'entrée identiques, les mêmes potentiel et variations de potentiel.

3. Source de tension de référence à barrière de potentiel suivant la revendication 1 ou 2, **caractérisée en ce qu'**il est prévu un dispositif de commande par lequel le dispositif (S1 à S4) de commutation est actionné de manière cyclique.

4. Source de tension de référence à barrière de potentiel suivant la revendication 3, **caractérisée en ce que** la cadence à laquelle le dispositif (S1 à S4) de commutation est actionné est constante dans le temps.

5. Source de tension de référence à barrière de potentiel suivant la revendication 3 ou 4, **caractérisée en ce que** la cadence à laquelle le dispositif (S1 à S4) de commutation est actionné a un rapport de cycle symétrique.

6. Source de tension de référence à barrière de potentiel suivant l'une des revendications précédentes, **caractérisée en ce qu'**il est prévu un filtre par lequel notamment des oscillations dont la fréquence correspond à la fréquence de la cadence de commutation et à des multiples entiers de cette fréquence sont filtrées des étages de sortie ou du signal de sortie des étages de sortie.

7. Procédé pour faire fonctionner une source de tension de référence à barrière de potentiel comportant un amplificateur (OP) opérationnel prévu notamment pour la compensation de température, l'amplificateur opérationnel comportant un premier étage (TE1, TL1) d'entrée qui comprend un premier transistor (TL1) de charge et sur lequel le potentiel d'un premier point (x5) nodal peut être prélevé, et comportant un deuxième étage (TE2, TL2) d'entrée qui comprend un deuxième transistor (TL2) de charge et sur lequel le potentiel d'un deuxième point (x6) nodal peut être prélevé, **caractérisé en ce que** l'on branche en va et vient entre deux états de manière cyclique la source de tension de référence à barrière de potentiel, en le premier état, le premier signal (E1) d'entrée étant appliqué au premier étage (TE1, TL1) d'entrée, le deuxième signal (E2) d'entrée étant appliqué au deuxième étage (TE2, TL2) d'entrée, et un signal (A) de sortie de l'étage d'entrée de l'amplificateur opérationnel étant prélevé sur le deuxième point (x6) nodal et le potentiel du premier point (x5) nodal étant appliqué comme tension de grille au premier transistor (TL1) de charge et, le deuxième état, le premier signal (E1) d'entrée étant appliqué au deuxième étage (TE2, TL2) d'entrée, le deuxième signal (E2) d'entrée étant appliqué au premier étage (TE1, TL1) d'entrée, et le signal (A) de sortie étant prélevé au premier point (x5) nodal et le potentiel du deuxième point (x6) nodal étant appliqué comme tension de grille au deuxième transistor (TL2) de chargé.

FIG 1    FIG 2

EP 0 897 143 B1

FIG 3